# EUROPEAN PATENT APPLICATION

(11) **EP 4 021 153 A1**
(43) Date of publication of application: **29.06.2022**
(21) Application number: 19943150.3
(22) Date of filing: 23.08.2019
(51) Int. Cl.: H05K 3/34, H05K 1/02

(54) **ELECTRONIC CIRCUIT DEVICE AND MANUFACTURING METHOD OF SAME**

(71) Applicant: Fuji Corporation, Chiryu-shi, Aichi 472-8686 (JP)
(72) Inventor: ICHINO, Shinji, Chiryu-shi, Aichi 472-8686 (JP); IWAKI, Noriaki, Chiryu-shi, Aichi 472-8686 (JP); HAMANE, Tsuyoshi, Chiryu-shi, Aichi 472-8686 (JP)
(74) Representative: Grünecker Patent- und Rechtsanwälte PartG mbB
(86) International application number: PCT/JP2019/033067
(87) International publication number: WO 2021/038631

(57) **Abstract**

An electronic circuit device (MID) including an inclined mounting surface 12 on which a wiring pattern is formed and circuit devices (13, 14) are mounted by reflow soldering is configured to provide adhesive sections (19, 21) for making the circuit devices adhere to the inclined mounting surface by an adhesive, as a positional deviation preventing section for preventing the circuit devices from sliding to be positionally deviated on the inclined mounting surface during a solder reflow. Alternatively, stopper section 31 for preventing a positional deviation may be provided as a positional deviation preventing section at a position in contact with a side edge of the inclined mounting surface on a deviation direction side of the circuit device.

## Description

### Technical Field

The present specification discloses a technique related to an electronic circuit device in which circuit devices are mounted by reflow soldering on an inclined mounting surface on which wiring patterns are formed, and a manufacturing method of the same.

### Background Art

Recently, a molded interconnect device (MID), which is a three-dimensional resin molded component on which wiring patterns are formed, has attracted attention as a mounting technique for realizing downsizing, reduction in the number of components, reduction in the number of assembly steps, and the like of electronic devices. The mounting technique of the MID is proposed in Patent Literature 1 (International Publication No. WO2018/163323) and the like. In a step of mounting circuit devices such as a semiconductor component and the like on a mounting surface of the MID, creamy solder is applied on electrodes on the mounting surface of the MID, the circuit devices are mounted on the mounting surface, the MID is carried into a reflow furnace, and then terminals of the circuit devices are reflow-soldered to the electrodes on the mounting surface, in the same manner as a general step of mounting a circuit device on a flat plate-shaped circuit board.

### Patent Literature

Patent Literature 1: International Publication No. WO 2018/163323

### Summary of the Invention

### Technical Problem

However, a mounting surface of a MID can also be an inclined surface without being limited to be a horizontal surface. When a circuit device mounted on an inclined mounting surface of the MID is reflow-soldered in a reflow furnace, the circuit device may slide to be positionally deviated on the inclined mounting surface during a solder reflow. A positional deviation of a circuit device during a solder reflow is a factor that reduces solder coupling reliability of the circuit device or causes a coupling failure. A problem of the positional deviation of the circuit device during the solder reflow is more remarkable as a weight of the circuit device increases.

### Solution to Problem

In order to solve the above-described problems, an electronic circuit device including an inclined mounting surface on which a wiring pattern is formed and a circuit device is mounted by reflow soldering, includes a positional deviation preventing section provided on the inclined mounting surface to prevent the circuit device from sliding to be positionally deviated on the inclined mounting surface during a solder reflow.

In this configuration, a positional deviation preventing section is provided on an inclined mounting surface, and thus, it is possible to prevent a circuit device from sliding to be positionally deviated on the inclined mounting surface during a solder reflow, to increase solder coupling reliability of the circuit device, and to prevent in advance a coupling failure caused by a positional deviation of the circuit device during the solder reflow.

### Brief Description of Drawings

Fig. 1 is a front view of a part of a MID according to a first embodiment.
Fig. 2 is a step diagram illustrating a MID component mounting process according to a first embodiment.
Fig. 3 is a front view of a part of a MID according to a second embodiment.
Fig. 4 is a front view of a part of a MID according to a third embodiment.

### Description of Embodiments

Hereinafter, three embodiments of first to third embodiments disclosed in the present specification will be described.

### First Embodiment

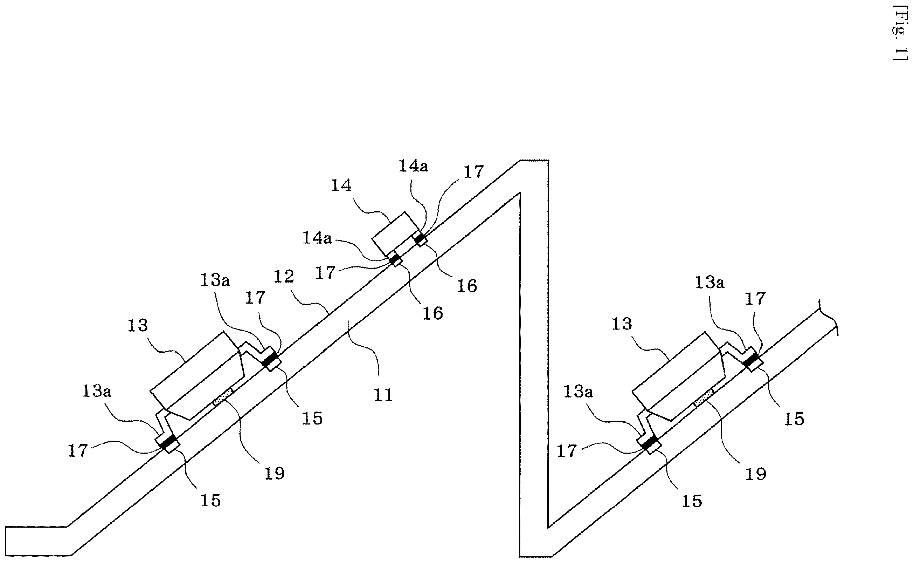

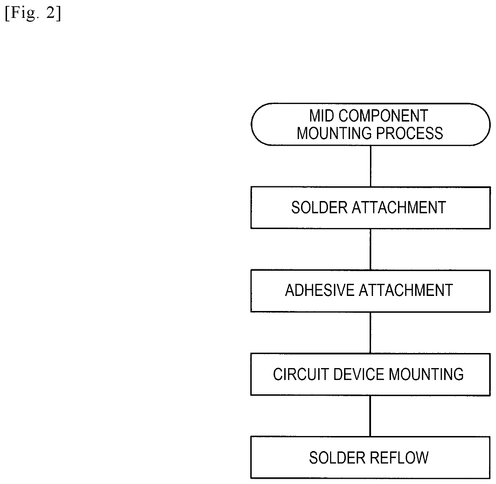

The first embodiment will be described based on Fig. 1 and Fig. 2.

First, a configuration of a MID, which is a three-dimensional resin molded component on which a wiring pattern is formed, will be described based on Fig. 1. Resin section 11 of the MID is molded into a three-dimensional shape having an inclined surface by injection molding, mold molding, or the like of an insulating resin. The inclined surface of a front surface of resin section 11 is inclined mounting surface 12 on which multiple circuit devices 13 and 14 configuring an electric circuit are mounted. Respective circuit devices 13 and 14 are various circuit components such as a semiconductor component, a capacitor, a resistor, and a connector.

A wiring pattern (not illustrated) is formed on inclined mounting surface 12 by a wiring pattern forming technique, and furthermore, electrodes 15 and 16 (pads, lands, or the like) connected to the wiring pattern are formed at positions of inclined mounting surface 12 to which terminals 13a and 14a (leads, bumps, or the like) of circuit devices 13 and 14 are reflow-soldered. Terminals 13a and 14a of circuit devices 13 and 14 are coupled to electrodes 15 and 16 of inclined mounting surface 12 by solder 17. A shape of resin section 11 of the MID may be any shape as long as resin section 11 has a three-dimensional shape having inclined mounting surface 12.

Multiple circuit devices 13 and 14 are mounted on inclined mounting surface 12 by reflow soldering, and adhesive section 19 is provided as a positional deviation preventing section at a position in which circuit device 13 having at least a predetermined weight or at least a predetermined size that may slide to be positionally deviated on inclined mounting surface 12 during a solder reflow is mounted, among multiple circuit devices 13 and 14, and circuit device 13 adheres to inclined mounting surface 12 by adhesive section 19.

In the first embodiment, adhesive section 19 makes a part (body part) of circuit device 13 other than terminal 13a adhere to inclined mounting surface 12 by an insulating adhesive.

Next, a MID component mounting process will be described based on Fig. 2. First, creamy solder 17 is attached to electrodes 15 and 16 of inclined mounting surface 12. At this time, for example, creamy solder 17 is attached to a lower end of a transfer pin (not illustrated) and transferred to electrodes 15 and 16 of inclined mounting surface 12. Creamy solder 17 may be attached to electrodes 15 and 16 by using an attachment method other than transfer.

Thereafter, an insulating adhesive serving as adhesive section 19 is attached to a predetermined position of inclined mounting surface 12 which faces a body part of circuit device 13 to be mounted. At this time, for example, insulating adhesive 19 is attached to a lower end of a transfer pin (not illustrated) and transferred to a predetermined position of inclined mounting surface 12. Insulating adhesive 19 may be attached thereto by using an attachment method other than transfer.

Meanwhile, an order of a step of attaching insulating adhesive 19 to a predetermined position of inclined mounting surface 12 and a step of attaching creamy solder 17 to electrodes 15 and 16 of inclined mounting surface 12 may be reversed, and insulating adhesive 19 is attached to a predetermined position of inclined mounting surface 12, and then creamy solder 17 may be attached to electrodes 15 and 16 of inclined mounting surface 12.

In a step of attaching creamy solder 17 and insulating adhesive 19, creamy solder 17 and insulating adhesive 19 are attached to each other in a state where the MID is held by a robot (not illustrated) and inclined mounting surface 12 is tilted until becoming horizontal.

After creamy solder 17 and insulating adhesive 19 are attached, circuit devices 13 and 14 are mounted on inclined mounting surface 12 by using a component mounting machine (not illustrated). Thereby, a body part of circuit device 13 having at least a predetermined weight or at least a predetermined size that may slide to be positionally deviated on inclined mounting surface 12 during a solder reflow is brought into a state where the body part adheres to inclined mounting surface 12 by insulating adhesive 19.

In a step of mounting circuit devices 13 and 14, circuit devices 13 and 14 are mounted on inclined mounting surface 12 in a state where the MID is held by a robot (not illustrated) and the MID is tilted until inclined mounting surface 12 becomes horizontal.

Thereafter, the MID is carried into a reflow furnace (not illustrated) to reflow-solder terminals 13a and 14a of circuit devices 13 and 14 to electrodes 15 and 16 of inclined mounting surface 12. In this solder reflow step, solder 17 is reflowed while inclined mounting surface 12 is in an inclined state only when the MID is mounted on a conveyance pallet (not illustrated). This is because there is no space, in the reflow furnace, for arranging the robot that holds the MID in a tilted state. In addition, although it is conceivable to carry the MID into the reflow furnace in a state of being tilted by using a jig or the like on the conveyance pallet, when the MID is in a tilted state, a height dimension of the MID is generally increased, and thus, the MID interferes with an entrance of the reflow furnace so as not to be carried into the reflow furnace.

In the first embodiment, a body part of circuit device 13 having at least a predetermined weight or at least a predetermined size or more that may slide to be positionally deviated on inclined mounting surface 12 during a solder reflow adheres to inclined mounting surface 12 by insulating adhesive 19, and thus, it is possible to prevent circuit device 13 from sliding to be positionally deviated on inclined mounting surface 12 during the solder reflow, to increase solder coupling reliability of circuit device 13, and to prevent in advance a coupling failure caused by a positional deviation of circuit device 13 during the solder reflow.

Meanwhile, in the first embodiment, although small and light-weight circuit device 14 that may not slide to be positionally deviated on inclined mounting surface 12 during a solder reflow does not adhere to inclined mounting surface 12, it is needless to say that small and light-weight circuit device 14 may also adhere to inclined mounting surface 12.

### Second Embodiment

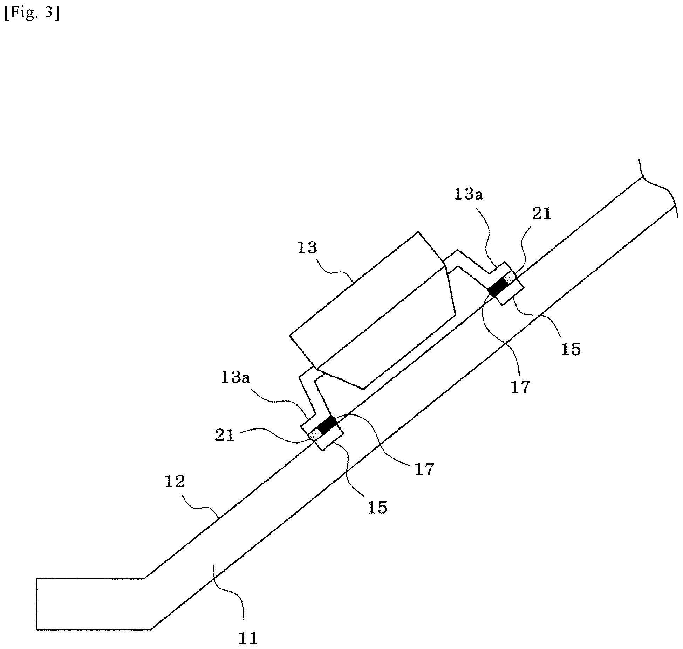

Next, a second embodiment will be described based on Fig. 3. However, the same reference numerals are assigned to substantially the same parts as in the first embodiment, and descriptions thereof are omitted or simplified, and different parts will be mainly described.

In the first embodiment, the body part of circuit device 13 adheres to inclined mounting surface 12 by insulating adhesive 19, whereas in the second embodiment illustrated in Fig. 3, at least one terminal 13a of circuit device 13 and electrode 15 of inclined mounting surface 12 adhere to each other by conductive adhesive 21 (adhesive section). In this case, conductive adhesive 21 is attached to only a part of electrode 15 by transfer or the like and attached creamy solder 17 to the rest part of electrode 15 by transfer or the like. In this case, solder coupling reliability between terminal 13a of circuit device 13 and electrode 15 can be secured by using conductive adhesive 21.

Also in the second embodiment described above, the same advantages as in the first embodiment described above can be obtained.

### Third Embodiment

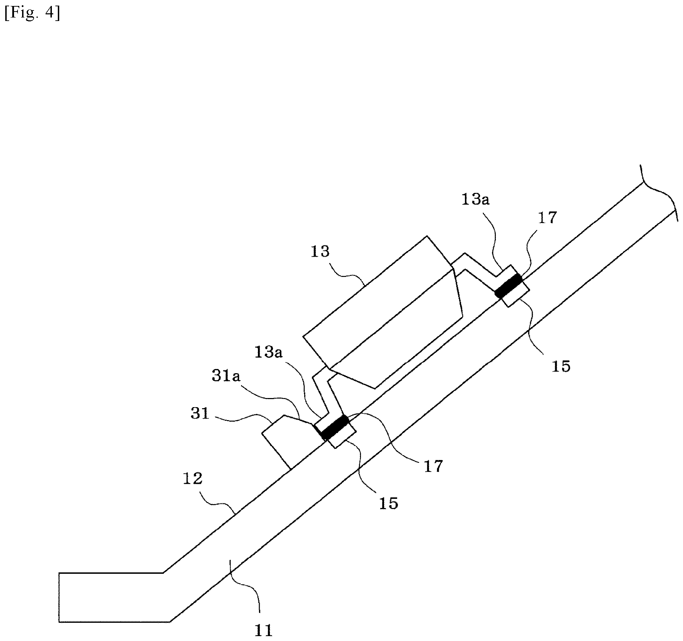

Next, a third embodiment will be described based on Fig. 4. However, the same reference numerals are assigned to substantially the same parts as in the first and second embodiments, and descriptions thereof are omitted or simplified, and different parts will be mainly described.

In the first and second embodiments described above, circuit device 13 adheres to inclined mounting surface 12 by adhesive sections 19 and 21 to prevent a positional deviation of circuit device 13 during a solder reflow, but in the third embodiment illustrated in Fig. 4, stopper section 31 for preventing a positional deviation is provided as a positional deviation preventing section at a position in contact with a side edge (a side edge of terminal 13a positioned on a deviation direction side of circuit device 13 in the third embodiment) of inclined mounting surface 12 on a deviation direction side of circuit device 13, and thus, a positional deviation of circuit device 13 during a solder reflow is prevented by stopper section 31. Inclined guide surface 31a for guiding terminal 13a of circuit device 13 to electrode 15 side of inclined mounting surface 12 is formed on circuit device 13 side on an upper part of stopper section 31.

In this case, stopper section 31 may be integrally molded on inclined mounting surface 12 of resin section 11 of a MID, or stopper section 31 formed separately from resin section 11 of the MID may be fixed to resin section 11 by adhesion, welding, screwing, engagement, or the like. A shape of stopper section 31 may be any shape as long as stopper section 31 has a protrusion shape capable of preventing a positional deviation of circuit device 13 during a solder reflow.

Alternatively, a stopper section in contact with a side edge of a body part which is a part other than terminal 13a of circuit device 13 may be provided on inclined mounting surface 12 to prevent a positional deviation of circuit device 13 during a solder reflow by the stopper section.

Also in the present third embodiment described above, the same advantages as in the first embodiment described above can be obtained.

Meanwhile, the present invention is not limited to each of the first to third embodiments, and it is needless to say that various modifications can be made without departing from the gist, for example, a shape of resin section 11 of a MID may be changed, the types and number of circuit devices 13 and 14 to be mounted on inclined mounting surface 12 of resin section 11 may be changed, resin section 11, a wiring pattern, and electrodes 15 and 16 of the MID may be formed by a 3D printer, or the like.

### Reference Signs List

11 ... resin section, 12 ... inclined mounting surface, 13, 14 ... circuit device, 13a, 14a ... terminal, 15, 16 ... electrode, 17 ... solder, 19 ... adhesive section (insulating adhesive), 21 ... adhesive section (conductive adhesive), 31 ... stopper section for preventing a positional deviation, 31a ... guide surface

## Claims

1. An electronic circuit device including an inclined mounting surface on which a wiring pattern is formed and a circuit device is mounted by reflow soldering, the electronic circuit device comprising:
a positional deviation preventing section provided on the inclined mounting surface to prevent the circuit device from sliding to be positionally deviated on the inclined mounting surface during a solder reflow.

2. The electronic circuit device according to claim 1, wherein the positional deviation preventing section is an adhesive section that makes the circuit device adhere to the inclined mounting surface by an adhesive.

3. The electronic circuit device according to claim 2, wherein the adhesive section makes a part of the circuit device other than a terminal adhere to the inclined mounting surface by an insulating adhesive.

4. The electronic circuit device according to claim 2, wherein the adhesive section makes at least one terminal of the circuit device and an electrode of the wiring pattern of the inclined mounting surface adhere to each other by a conductive adhesive.

5. The electronic circuit device according to claim 1, wherein the positional deviation preventing section is a stopper section for preventing a positional deviation which is provided at a position in contact with a side edge of the inclined mounting surface on a deviation direction side of the circuit device.

6. The electronic circuit device according to any one of claims 1 to 5, wherein multiple circuit devices are mounted on the inclined mounting surface by reflow soldering, and the positional deviation preventing section is provided only for a circuit device having at least a predetermined weight or at least a predetermined size among the multiple circuit devices.

7. A method of manufacturing the electronic circuit device according to any one of claims 2 to 4, the method comprising:
a step of attaching solder to the inclined mounting surface;
a step of attaching an adhesive to the inclined mounting surface;
a mounting step of mounting the circuit device on the inclined mounting surface to make the circuit device adhere to the inclined mounting surface by the adhesive; and
a step of reflow-soldering a terminal of the circuit device adhered to the inclined mounting surface to an electrode of a wiring pattern on the inclined mounting surface.

8. The method of manufacturing the electronic circuit device according to claim 7, wherein, in the mounting step, the circuit device is mounted on the inclined mounting surface in a state where a three-dimensional molded component on which the inclined mounting surface is formed is tilted until the inclined mounting surface becomes horizontal.
